# EUROPÄISCHE PATENTSCHRIFT

(11) **EP 2 046 506 B1**
(45) Veröffentlichungstag und Bekanntmachung des Hinweises auf die Patenterteilung: **09.01.2013**
(21) Anmeldenummer: 07801453.7
(22) Anmeldetag: 19.07.2007
(51) Int. Cl.: B05D 7/22, B05D 7/24, C23C 16/04, C08J 7/18, C23C 16/507, H01J 37/32

(54) **VERFAHREN ZUM PLASMABEHANDELN EINER OBERFLÄCHE**
METHOD FOR THE PLASMA TREATMENT OF A SURFACE
PROCÉDÉ DE TRAITEMENT PLASMA D'UNE SURFACE

(30) Priorität: 31.07.2006 DE 102006036536
(43) Veröffentlichungstag der Anmeldung: 15.04.2009
(73) Patentinhaber: Fraunhofer-Gesellschaft zur Förderung der angewandten Forschung e.V., 80686 München (DE)
(72) Erfinder: THOMAS, Michael, 31275 Lehrte (DE); SCHLITTENHARDT, Eugen, 38448 Wolfsburg (DE)
(74) Vertreter: Pfenning, Meinig & Partner GbR
(86) Internationale Anmeldenummer: PCT/EP2007/006615
(87) Internationale Veröffentlichungsnummer: WO 2008/014915

(56) Entgegenhaltungen:
- WO-A-02/26401
- WO-A-95/22413
- DE-A1- 4 437 050
- US-A- 4 066 037
- US-A- 5 833 752
- US-A1- 2002 092 617
- US-A1- 2006 156 983
- US-B1- 6 204 605

## Beschreibung

Die vorliegende Erfindung betrifft ein Verfahren zum Plasmabehandeln einer Oberfläche in einem Hohlkörper.

Aus dem Stand der Technik ist es an sich bekannt, Oberflächen mit einem Plasma zu behandeln, um dadurch veränderte Oberflächeneigenschaften zu erhalten. So zeigt die Druckschrift DE 43 18 086 A1 beispielsweise ein solches Verfahren, bei dem ein Plasma innerhalb eines Hohlkörpers gezündet wird. Verfahren der dort beschriebenen Art bringen jedoch den Nachteil eines verhältnismäßig hohen Aufwands mit sich, weil die an einer inneren Oberfläche zu behandelnden Hohlkörper dabei zunächst evakuiert werden müssen, um einen für eine Zündung eines Niederdruck-Plasmas hinreichend niedrigen Innendruck herzustellen.

Der vorliegenden Erfindung liegt also die Aufgabe zugrunde, ein vergleichbares Verfahren zum Behandeln einer Oberfläche in einem Hohlkörper zu entwickeln, das sich mit deutlich geringerem Aufwand realisieren lässt.

Diese Aufgabe wird erfindungsgemäß gelöst durch ein Verfahren mit den Merkmalen des Anspruchs 1. Vorteilhafte Ausgestaltungen und Weiterentwicklungen der Erfindung ergeben sich mit den Merkmalen der Unteransprüche.

Das vorgeschlagene Verfahren umfasst folgende Verfahrensschritte:
- Füllen eines Hohlkörpers, der eine Wand aus dielektrischem Material aufweist, mit einem Prozessgas,
- gasdichtes Verschließen des Hohlkörpers,
- Einbringen des gasdicht verschlossenen Hohlkörpers in einen Raum mit mindestens zwei Elektroden, wobei in diesem Raum außerhalb des Hohlkörpers ein Außendruck von mindestens 0,5 bar herrscht, während in einem Innenraum des Hohlkörpers ein Innendruck von ebenfalls mindestens 0,5 bar herrscht, und wobei der Raum zwischen den Elektroden mit einem Gas gefüllt ist, das bei dem Außendruck eine höhere Zündfeldstärke aufweist, als das Prozessgas bei dem Innendruck und
- Zünden eines Plasmas im Innenraum des Hohlkörpers durch Anlegen einer hinreichend hohen Wechselspannung an die Elektroden.

Durch dieses Verfahren wird eine Außenfläche eines zuvor in den Hohlkörper eingebrachten Gegenstands behandelt, also beschichtet und/oder funktionalisiert werden. Gegenüber den bekannten Niederdruckverfahren zeichnet sich das hier vorgeschlagene Verfahren dabei durch einen ausgesprochen geringen Aufwand und damit geringe Prozess- und Investitionskosten aus, weil aufgrund des verhältnismäßig hohen Außendrucks auf ein kompliziertes Evakuieren einer zur Durchführung des Verfahrens verwendeten Vorrichtung verzichtet werden kann. Das wiederum wird möglich, weil das Plasma selbst bei einem verhältnismäßig hohen Druck, nämlich dem oben genannten Innendruck, gezündet wird. Dabei ist es ausgesprochen überraschend, dass sich die gewünschten Effekte mit einem Plasma erzielen lassen, das bei derart hohem Druck erzeugt wird.

Dadurch, dass ein aufwendiges Evakuieren einer Prozesskammer überflüssig wird, lässt sich das vorgeschlagene Verfahren auch sehr leicht in bestehende Prozessketten integrieren und damit als kontinuierlicher Prozess ausführen. Ferner ist das Verfahren ausgesprochen flexibel bezüglich des für den Hohlkörper verwendeten dielektrischen Materials und einer Geometrie des Hohlkörpers. Als Material für die Wand des Hohlkörpers kommt insbesondere Polypropylen oder ein anderer Kunststoff, Glas oder Keramik in Frage. Dabei kann der Hohlkörper als Beutel, also insbesondere mit flexiblen Wänden, oder auch als Flasche oder Kanister ausgeführt sein. Vorteilhafterweise ist das Verfahren auch mit einem nur geringen Verbrauch an Prozessgas verbunden, weil der Hohlkörper nur einmal befüllt werden muss, ohne dass ein Prozessgasstrom während eines Brennens des Plasmas aufrechterhalten werden müsste. Damit wird auch ein Einsatz von teuren Gasen, wie beispielsweise Helium, als Prozessgas wirtschaftlich.

Eine typische Ausführung des Verfahrens sieht vor, dass ausschließlich im Innenraum des Hohlkörpers ein Plasma gezündet wird. Das ist möglich, weil das Prozessgas innerhalb des Hohlkörpers eine niedrigere Zündfeldstärke (und damit eine niedrigere Zündspannung) aufweist als das im Raum außerhalb des Hohlköpers vorhandene Gas.

Bevorzugte Ausführungen sehen vor, dass der Außendruck und/oder der Innendruck nicht mehr als 10 bar beträgt, damit das Erzeugen des Plasmas keine zu hohen Temperaturen mit sich bringt. Vorzugsweise ist der Außendruck und/oder der Innendruck mit Werten von zwischen 0,8 bar und 2 bar zu wählen. Drücke in diesem Bereich lassen sich mit ausgesprochen geringem Aufwand herstellen und erlauben andererseits eine Erzeugung eines Plasmas bei nicht allzu hohen Temperaturen. Besonders einfach lässt sich das Verfahren ausführen, wenn es mit einem dem Atmosphärendruck entsprechenden Außendruck durchgeführt wird. Der Innendruck wiederum kann genauso groß wie der Außendruck oder geringfügig größer, vorzugsweise nicht mehr als 1 bar über dem Außendruck gewählt werden. Das erlaubt eine besonders einfache Befüllung des Hohlkörpers mit dem Prozessgas ohne aufwendiges Abpumpen bei einem zugleich nicht zu hohen Innendruck, der zu hohe Temperaturen des Plasmas und daher Beschädigungen des Hohlkörpers mit sich bringen könnte. Wenn der Innendruck mindestens so groß gewählt wird wie der Außendruck, wird einerseits das Verfahren vereinfacht, weil das Befüllen des Hohlkörpers dann keine Schwierigkeiten bereitet, andererseits wird - insbesondere bei Verwendung eines Hohlkörpers mit flexiblen Wänden - gewährleistet, dass der Hohlkörper seine Form behält.

Typische Anwendungen des Verfahrens sehen vor, dass der Hohlkörper eine Wanddicke von zwischen 10 µm und 5 mm, vorzugsweise zwischen 50 µm und 2 mm hat. Der Hohlkörper kann insbesondere so dimensioniert sein, dass er einen kleinsten Durchmesser (größte Ausdehnung in der Richtung, in der diese am geringsten ist) von mindestens 2 cm, vorzugsweise von mindestens 6 cm hat. Dadurch wird gewährleistet, dass innerhalb des Hohlkörpers genügend Prozessgas zur Verfügung steht, um eine gleichmäßige Oberflächenbehandlung durch das Plasma ohne Nachfüllen von Prozessgas zu erreichen.

Mit Blick auf eine möglichst gleichmäßige Oberflächenbehandlung eines um Hohlkörper befindlichen Gegenstands wird das Plasma bei bevorzugten Ausführungen der Erfindung als Volumenplasma erzeugt, das sich von einer Wand des Hohlkörpers bis zu einer gegenüberliegenden Wand des Hohlkörpers erstreckt und u.U. den gesamten Innenraum des Hohlkörpers ausfüllen kann.

Um ein Plasma gewünschter Qualität zu erzeugen, kann die Wechselspannung zwischen den Elektroden so gewählt werden, dass sie eine Amplitudenspannung von zwischen 0,1 kV und 50 kV, vorzugsweise von zwischen 1 kV und 20 kV hat. Vorzugsweise ist zum Zünden und Aufrechterhalten des Plasmas eine elektrische Energie von zwischen 100 W und 5 kW einzuspeisen. Für eine befriedigende Oberflächenbehandlung ist es von Vorteil, wenn zu behandelnde Teile der Oberfläche für eine Dauer von zwischen 5 s und 300 s mit dem Plasma in Kontakt sind. Es kann vorgesehen sein, dass der Hohlkörper mit einer vorzugsweise gleichmäßigen Bewegung zwischen den Elektroden hindurchbewegt wird, während an den Elektroden die Wechselspannung anliegt und das Plasma aufrechterhalten wird, damit alle zu behandelnden Teile der Oberfläche für eine geeignete Dauer mit dem Plasma Kontakt haben.

Bei den Elektroden kann es sich um Stifte (Stäbe) oder um mindestens einen Stift und eine Platte oder um zwei Platten handeln. Dabei bringt eine Verwendung von Stiften den Vorteil mit sich, dass verhältnismäßig einfach hinreichend hohe Feldstärken zu erzielen sind, um eine Koronaentladung auszulösen, während eine Verwendung von Platten für eine Erzeugung eines Volumenplasmas größeren Durchmessers von Vorteil ist. Besonders vorteilhaft ist demnach eine Anordnung, bei der eine Elektrode als Platte ausgeführt ist, während die zweite Elektrode als Stift ausgeführt ist, an dessen Stelle auch mehrere Stifte gleicher Polung verwendet werden können. Zum Zweck einer möglichst gleichmäßigen Oberflächenbehandlung kann mindestens eine Elektrode, vorzugsweise eine stiftförmige Elektrode oder mehrere stiftförmige Elektroden, bewegt werden, während die Oberfläche durch das Plasma behandelt wird.

Eine Ausgestaltung der Erfindung sieht vor, dass der Hohlkörper nach dem Einbringen in den Raum zwischen den Elektroden an mindestens einer Elektrode anliegt. Dadurch wird der außerhalb der Elektrode verbleibende Raum reduziert, was es erleichtert, das Plasma ausschließlich im Innenraum des Hohlkörpers brennen zu lassen.

Als Prozessgas kann insbesondere Helium oder Argon oder ein anderes Edelgas oder ein eines oder mehrere dieser Edelgase enthaltendes Gas verwendet werden. Damit läßt sich eine hinreichend niedrige Zündfeldstärke im Innenraum des Hohlkörpers realisieren. Um eine höherere Zündfeldstärke außerhalb des Hohlkörpers zu erreichen kann als den Raum zwischen den Elektroden außerhalb des Hohlkörpers füllendes Gas statt Luft auch ein Löschgas wie bspw. SF₆ verwendet werden. In dem Fall könnte als Prozessgas auch Luft oder ein auf Luft basiertes Prozessgas verwendet werden.

Vorteilhaft ist es, dem Prozessgas einen Prekursor oder mehrere Prekursoren beizumischen, die eine gewünschte Modifikation der behandelten Oberfläche mit sich bringen, indem sie zu einer Funktionalisierung der Oberfläche beitragen und/oder eine Beschichtung der Oberfläche durch Ablagerung bewirken. In besonders einfacher Weise kann ein solcher Prekursor dem Prozessgas beigefügt werden, indem das Prozessgas bzw. ein Ausgangsgas für das Prozessgas, beispielsweise Helium, vor dem Füllen des Hohlkörpers durch den entsprechenden Prekursor geleitet wird. Je nach erwünschter Wirkung können sehr verschiedene Prekursoren verwendet werden. So kann beispielsweise eine Verwendung Siliziumbasierter Prekursoren zu einer Bildung einer Migrations- oder Diffusionsbarriere auf der behandelten Oberfläche führen. Insbesondere zur Erzielung hydrophilerer Oberflächen kann z.B. Tetramethoxysilan (TMOS) als Prekursor verwendet werden. Durch eine Verwendung von Hexamethyldisiloxan (HMDSO) oder u.U. auch fluorhaltigen Prekursoren lassen sich hydrophobe oder oleophobe Oberflächen schaffen. Proteinabweisende Oberflächen können beispielsweise durch eine Verwendung von Diethylenglycol-Monovinylether als Prekursor realisiert werden. Schließlich ist es möglich, zum Funktionalisieren der behandelten Oberfläche Precursoren zu verwenden, die Amino-, Epoxy-, Hydroxy- oder Carbonsäuregruppen erzeugen. Als Aminogruppen erzeugende Prekursoren kommen beispielsweise Formiergas, Aminopropyltrimethoxysilan (APTMS) oder Ammoniak in Frage, als Epoxygruppen erzeugender Prekursor beispielsweise Glycidylmethacrylat, zum Erzeugen von Hydroxygruppen können sauerstoffhaltige Prekursoren verwendet werden, und als Prekursoren zum Erzeugen von Carbonsäuregruppen eignen sich beispielsweise Maleinsäureanhydrid oder Acrylsäure.

Mit dem beschriebenen Verfahren wird eine Außenfläche eines zuvor in den Hohlkörper eingebrachten Gegenstandes - oder mehrerer in den Hohlkörper eingebrachter Gegenstände - behandelt, insbesondere beschichtet oder in anderer Weise funktionalisiert. Dazu kann der entsprechende Gegenstand beispielsweise in einen Beutel eingebracht werden, der daraufhin, beispielsweise durch Verschweißen, so weit geschlossen wird, dass nur noch eine kleine Öffnung zum Zuführen des Prozessgases übrig bleibt, worauf das Prozessgas in den Hohlkörper eingefüllt und dieser vollständig geschlossen wird. Das gasdichte Verschließen des Hohlkörpers kann unter Umständen auch (das gilt auch für die Ausführung des Verfahrens, bei der lediglich die innere Wandobefläche des Hohlkörpers behandelt wird) durch Schließen eines Ventils einer Prozessgaszufuhr erfolgen.

Selbstverständlich können auch Behälter anderer Art als Hohlkörper für solche Verfahren zum Behandeln einer Außenoberfläche von Gegenständen verwendet werden. Bei dem zu behandelnden Gegenstand kann es sich beispielsweise um einen Stopfen oder um eine Mikrotiterplatte handeln. Um eine gleichmäßig Oberflächenbehandlung eines solchen Gegenstandes zu erreichen, die den Gegenstand von jeder Seite erreicht, kann es vorgesehen sein, dass der Gegenstand durch Rütteln des Hohlkörpers während des Verfahrens, d.h. während des Brennen des Plasmas, bewegt wird.

Auch wenn das vorgeschlagene Verfahren in erster linie zum Beschichten von Gegenständen in Hohlkörpern eingesetzt wird, können diese in vorteilhafter Weise auch anschließend im Hohlkörper verbleiben, der dann als (von innen oberflächenbehandelte) Verpackung dienen kann. Zusätzlich ist es möglich, den Hohlkörper anschließend durch Absaugen zu entleeren und so eine Vakuumverpackung zu realisieren. Dabei können sowohl dem verpackten Gegenstand als auch der Vakuumverpackung selbst durch das Verfahren gewünschte Oberflächeneigenschaften verliehen werden.

Ausführungsbeispiele für die hier beschriebene Erfindung werden nachfolgend anhand der Figuren 1 bis 5 erläutert. Es zeigt
- Figur 1: ein Ausführungsbeispiel für eine Anordnung zum Durchführen eines erfindungsgemäßen Verfahrens mit zwei planaren Elektroden,
- Figur 2: eine andere Anordnung zur Durchführung eines solchen Verfahrens mit einer Stabelektrode und einer planaren Elektrode,
- Figur 3: eine vergleichbare Anordnung mit zwei Stabelektroden,
- Figur 4: eine andere Anordnung zur Durchführung eines vergleichbaren Verfahrens mit an einem Hohlkörper anliegend ausgeführten Elektroden und
- Figur 5: ein Beispiel für einen zur Durchführung eines erfindungsgemäßen Verfahrens verwendeten Hohlkörper mit zwei zu behandelnden Gegenständen.

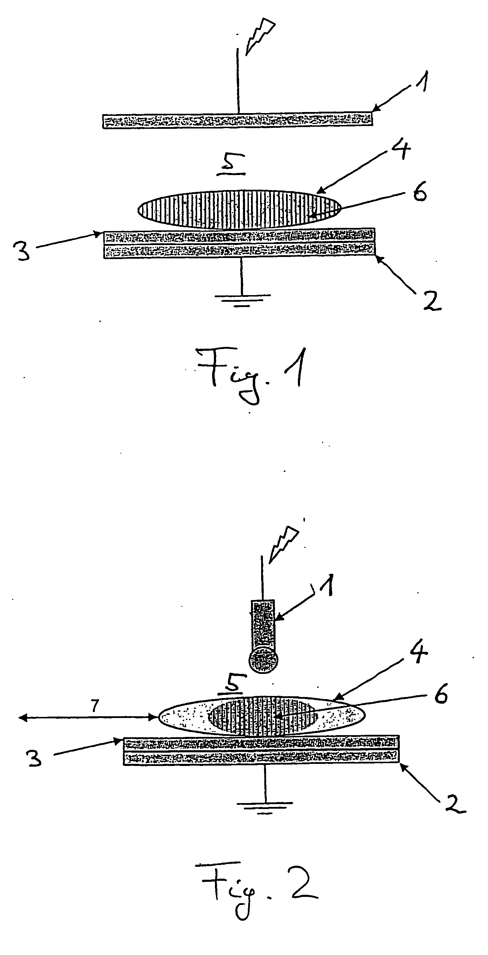

In Figur 1 ist eine Anordnung zu erkennen, die eine im vorliegenden Fall plattenförmige erste Elektrode 1 sowie eine parallel zu dieser angeordnete, ebenfalls plattenförmige zweite Elektrode 2 aufweist, auf der wiederum ein Dielektrikum 3 angeordnet ist. Zwischen der ersten Elektrode 1 und der zweiten Elektrode 2 ist eine elektrische Wechselspannung von vorliegend 1 kV bis 20 kV Amplitudenspannung und einer Frequenz im Bereich zwischen 10 kHz und 60 kHz anlegbar. Bei dem mit dieser Anordnung durchzuführenden Verfahren zum Plasmabehandeln einer inneren Wandoberfläche eines Hohlkörpers 4, der eine Wand aus Polypropylen aufweist, wird dieser Hohlkörper 4 zunächst mit einem Prozessgas gefüllt, im vorliegenden Fall mit Helium, wonach der Hohlkörper 4 durch Zuschweißen gasdicht verschlossen wird. Bei dem Hohlkörper 4 handelt es sich hier um einen Beutel mit flexiblen Wänden einer Wanddicke von etwa 100 µm.

Entsprechende Verfahren können auch mit anderen Hohlkörpern, wie beispielsweise Flaschen oder Kanistern, durchgeführt werden.

Der gasdicht verschlossene Hohlkörper wird dann in einen Raum 5 zwischen der ersten Elektrode 1 und der zweiten Elektrode 2 eingebracht, wobei in diesem Raum 5 außerhalb des Hohlkörpers 4 ein Außendruck von etwa 1 bar, genauer Atmosphärendruck, herrscht. Innerhalb des Hohlkörpers 4 herrscht ein geringfügig höherer Innendruck, wodurch der Hohlkörper 4 seine Form behält. Der Raum 5 zwischen den Elektroden 1 und 2 ist im vorliegenden Fall mit Luft gefüllt, die eine höhere Zündfeldstärke aufweist als das als Prozessgas verwendete Helium. Nach dem Eindringen des Hohlkörpers 4 in den genannten Raum 5 wird im Innenraum des Hohlkörpers 4 - und aufgrund der geringeren Zündfeldstärke des Prozessgases im Innenraum des Hohlkörpers 4 ausschließlich dort - durch die zwischen den Elektroden 1 und 2 angelegte Wechselspannung ein Plasma erzeugt, das eine Modifizierung der inneren Wandoberfläche des Hohlkörpers 4 bewirkt.

Als Material für die Wand des Hohlkörpers 4 kann genauso gut ein anderes dielektrisches Material, beispielsweise ein anderer Kunststoff, Glas oder Keramik, verwendet werden. Im vorliegenden Beispiel hat der Hohlkörper 4 einen kleinsten Durchmesser, hier einer Ausdehnung in vertikaler Richtung entsprechend, von etwa 7 cm. Bei dem durch die Wechselspannung erzeugten Plasma handelt es sich um ein Volumenplasma 6, das hier den gesamten Innenraum des Hohlkörpers 4 ausfüllt und sich insbesondere von einer Wand des Hohlkörpers 4 bis zu einer dieser gegenüberliegenden Wand des Hohlkörpers 4 erstreckt. Zum Zünden und Aufrechterhalten dieses Volumenplasmas 6 wird vorliegend eine elektrische Energie von etwa 500 Watt in das System eingespeist.

Bei der bislang beschriebenen Ausführung des Verfahrens wird die geringere Zündfeldstärke innerhalb des Hohlkörpers 4 im Vergleich zur Zündfeldstärke im Raum 5 außerhalb des Hohlkörpers dadurch erreicht, dass der Hohlkörper 4 mit Helium gefüllt ist. Als Prozessgas können zur Erreichung desselben Zwecks Argon oder ein anderes Edelgas oder eines oder mehrere dieser Edelgase enthaltende Gase verwendet werden. Alternativ oder zusätzlich kann der Raum 5 - der bei der einfachsten Auführung der Erfindung mit Luft gefüllt ist - außerhalb des Hohlkörpers 4 auch durch ein Löschgas, beispielsweise SF₆, gefüllt werden, um sicherzustellen, dass ausschließlich im Innenraum des Hohlkörpers 4 ein Plasma gezündet wird.

Schließlich kann dem Prozessgas, mit dem der Hohlkörper 4 gefüllt wird, auch ein Prekursor oder eine Mehrzahl von Prekursoren beigemischt werden. Das kann beispielsweise dadurch geschehen, dass das als Basis für das Prozessgas dienende Helium vor dem Füllen des Hohlkörpers 4 mit Prozessgas durch den entsprechenden Prekursor geleitet wird. Als Prekursoren kommen insbesondere Silizium-basierte Prekursoren wie z.B. TMOS, HMDSO, eventuell auch fluorhaltige Prekursoren, Amino-, Epoxy-, Hydroxy-, oder Carbonsäuregruppen erzeugende Prekursoren oder auch Diethylenglycol-Monovinylether in Frage. Je nach Art des verwendeten Prekursors oder der verwendeten Prekursoren kann die behandelte Oberfläche im Hohlkörper 4 Eigenschaften verschiedener Art erhalten, die weiter oben bereits angesprochen worden sind.

Figur 2 zeigt eine andere Anordnung für ein vergleichbares Verfahren. Wiederkehrende Merkmale sind hier mit den gleichen Bezugszeichen versehen. Unterschiede zum zuvor beschriebenen Verfahren ergeben sich nur dadurch, dass die erste Elektrode 1 im Gegensatz zur zweiten Elektrode 2 hier stabförmig bzw. stiftförmig ausgeführt ist. Bei dieser Anordnung können sehr leicht hohe elektrische Feldstärken im Raum 5 erreicht werden, was ein Zünden des Plasmas im Hohlkörper 4 erleichtert. Allerdings füllt das Volumenplasma 6 in diesem Fall den Hohlkörper 4 nicht vollständig aus. Um dennoch eine gleichmäßige Beschichtung der gesamten inneren Wandoberfläche des Hohlkörpers 4 zu erreichen, ist es vorgesehen, den Hohlkörper 4 während des Verfahrens in einer in der Figur 2 durch einen Doppelpfeil 7 gekennzeichneten Richtung durch die Anordnung hindurchzubewegen. Alternativ oder zusätzlich kann auch die erste Elektrode 1 bewegt werden, um eine gleichmäßige Behandlung der Oberfläche zu erreichen und eine Ausbildung zu hoher Temperaturen zu vermeiden. Anstelle der stiftförmigen ersten Elektrode 1 könnte auch eine Mehrzahl stiftförmiger oder stabförmiger Elektroden verwendet werden.

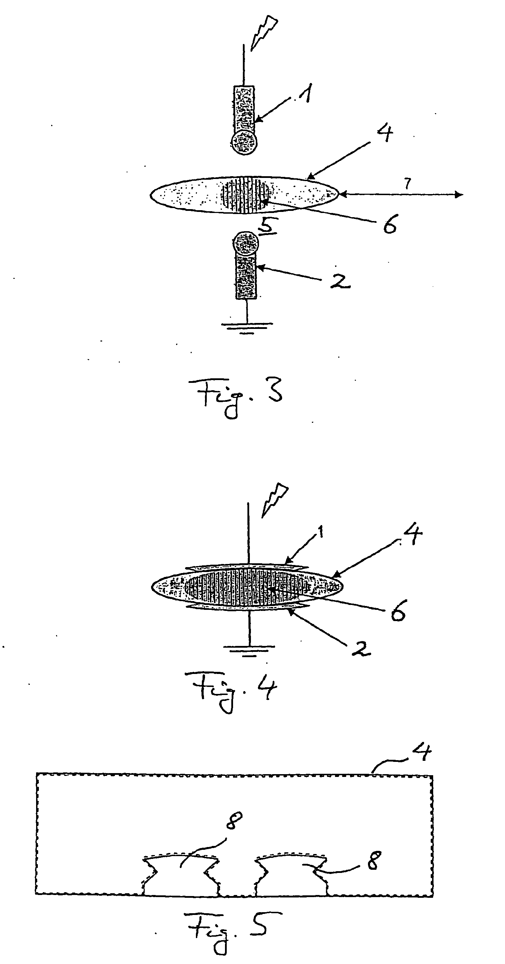

Wieder eine andere Anordnung für eine Durchführung eines vergleichbaren Verfahrens ist in der Figur 3 dargestellt. Wieder sind, wie auch in den folgenden Figuren, wiederkehrende Merkmale mit den gleichen Bezugszeichen versehen. Bei dem in der Figur 3 dargestellten Verfahren ist sowohl die erste Elektrode 1 als auch die zweite Elektrode 2 stiftförmig bzw. als Stabelektrode ausgeführt.

Wieder eine andere Ausführung eines vergleichbaren Verfahrens wird in der Figur 4 veranschaulicht. Unterschiede ergeben sich wieder nur in der genauen Gestaltung der Elektroden 1 und 2, die hier so ausgeführt sind, dass sie direkt auf einer Außenoberfläche des Hohlkörpers 4 anliegen.

Bei den bislang beschriebenen Ausführungsbeispielen dient das vorgeschlagene Verfahren auch zur Modifizierung, also zum Beschichten und/oder zum Funktionalisieren, einer inneren Wandoberfläche des Hohlkörpers 4, bei dem es sich beispielsweise um ein Verpackungsmaterial handeln kann. Es ist uber vorgesehen, dass vor dem Füllen des Hohlkörpers 4 mit dem jeweiligen Prozessgas ein Gegenstand, beispielsweise ein Stopfen oder eine Mikrotiterplatte, in den Hohlkörper 4 eingebracht wird, so dass das Verfahren in erster Linie zum Modifizieren, also zum Beschichten und/oder Funktionalisieren, einer Außenoberfläche dieses Gegenstandes dient.

Figur 5 zeigt einen entsprechenden Hohlkörper 4, in den zwei Stopfen als zu beschichtende Gegenstände eingebracht sind. Gestrichelt dargestellt ist eine Beschichtung, die sich bei einer Plasmabehandlung beschriebener Art durch Einbringen dieses Hohlkörpers 4 mit den Stopfen 8 in ein elektrisches Wechselfeld bildet. Ausgespart werden dabei zunächst Teile der - Außenoberflächen der Stopfen 8, die an der inneren Wandoberfläche des Hohlkörpers 4 anliegen. Um eine gleichmäßige Beschichtung der Stopfen 8 von allen Seiten zu erreichen, können diese während der Plasmabehandlung, beispielsweise durch eine Rüttelbewegung des Hohlkörpers 4, so bewegt werden, dass alle Seiten der Stopfen 8 dem Plasma ausgesetzt werden. Das Verschließen des Hohlkörpers 4 nach dem Befüllen mit dem Prozessgas kann auch dadurch geschehen, dass ein Ventil in einer Prozessgaszufuhr geschlossen wird. Anstelle der Stopfen 8 können selbstverständlich auch Gegenstände anderer Art und vorzugsweise dreidimensionaler Form behandelt werden, die bei bevorzugten Ausführungen erfindungsgemäßer Verfahren aus dielektrischen Materialien bestehen sollten. Eine Weiterbildung des Verfahrens sieht schließlich vor, dass die in beschriebener Weise behandelten Gegenstände anschließend in dem Hohlkörper 4 verbleiben, der dann als Verpackung für die behandelten Gegenstände dient. Eventuell kann dabei das Prozessgas nach dem beschriebenen Verfahren zur Realisierung einer Vakuumverpackung aus dem Hohlkörper 4 abgesaugt werden.

Drei Anwendungsbeispiele seien nachfolgend im einzelnen beschrieben.

### a) Dauerhafte Veränderung der Oberflächenspannung:

Durch Durchleiten von Helium durch einen flüssigen Prekursor in einem Bubblersystem wird ein Kunststoffbeutel oder Plastikröhrchen aus Polypropylen mit dem Prozessgas befüllt. Als Precursor für die Erzeugung hydrophiler Schichten wird TMOS verwendet und noch etwas Sauerstoff hinzugegeben. Die Kunststoffbeutel aus Polypropylen oder die Plastikröhrchen werden bei einer Leistung von 300 Watt während einer Dauer von etwa 10 Sekunden behandelt. Die Oberflächenspannung einer Wand des Kunststoffbeutels bzw. Plastikröhrchens steigt dabei von 34 mN/m auf einen Wert von mehr als 56 mN/m an.

Für eine Erzeugung hydrophober Schichten wird in einem entsprechenden Verfahren HMDSO als Precursor verwendet. Die Kunststoffbeutel oder Plastikröhrchen aus Polypropylen werden wieder bei einer Leistung von etwas 300 Watt so behandelt, dass jeder Teil der zu behandelnden Oberfläche während einer Dauer von etwa 20 Sekunden dem Plasma ausgesetzt ist. die Oberflächenenergie sinkt dann von 34 mN/m auf einen Wert von weniger als 18 mN/m.

### b) Erzeugung funktioneller Gruppen:

In einem medizinischen Kultivierungsbeutel wird Helium und APTMS eingeleitet. Der Kultivierungsbeutel wird bei einer Leistung von etwa 500 Watt während einer Dauer von etwa 20 Sekunden mit einem den ganzen Kultivierungsbeutel füllenden Plasma behandelt. Nach einem Öffnen des Beutels wird eine innere Oberfläche des Beutels mittels IR-Spektroskopie untersucht. Es zeigt sich ein Infrarotspektrum mit Banden für Siliziumoxyd- sowie für Aminogruppen. An diese Gruppen können nun beispielsweise Biomoleküle koppeln.

### c) Schichten auf verschiedenen Bauteilen

In einen Polyethylenbeutel werden z.B. Mikrotiterplatten oder Naturkautschukstopfen hineingelegt, wonach der Polyethylenbeutel mit einem Gasgemisch aus Helium und HMDSO gefüllt wird. Der Polyethylenbeutel wird dann verschlossen und bei einer Leistung von 500 Watt so behandelt, dass in seinem Inneren während einer Dauer von etwa 10 Sekunden ein Plasma brennt. Danach wird der Polyethylenbeutel erneut befüllt und nochmals in gleicher Weise behandelt. Die Oberflächenenergie auf einer Beutelinnenseite beträgt danach weniger als 18 mN/m, und auf der Mikrotiterplatte bzw. dem Stopfen sind neben den hydrophoben Eigenschaften mittels IR-Spektroskopie überall durch das Plasma erzeugte Beschichtungen nachzuweisen.

Vorgeschlagen wird mit der hier beschriebenen Erfindung insbesondere ein vorteilhaft einfaches und ohne hohen Prozessgasverbrauch realisierbares Verfahren zum Plasmabehandeln einer Oberfläche in einem Hohlkörper, das folgende Verfahrensschritte, vorzugsweise in Reihenfolge ihrer Nennung, umfasst:
- Füllen eines Hohlkörpers, der eine Wand aus dielektrischem Material aufweist, mit einem Prozessgas,
- vollständig gasdichtes Verschließen des Hohlkörpers,
- Einbringen des Hohlkörpers in einen Raum zwischen mindestens zwei Elektroden, wobei in diesem Raum ein Außendruck von mindestens 0,5 bar herrscht, während in einem Innenraum des Hohlkörpers ein Innendruck von ebenfalls mindestens 0,5 bar herrscht, wobei der Raum zwischen den Elektroden mit einem Gas gefüllt ist, das bei dem Außendruck eine höhere Zündfeldstärke hat als das Prozessgas bei dem Innendruck,
- Zünden eines Plasmas in dem Innenraum des gasdicht verschlossenen Hohlkörpers durch Anlegen einer hinreichend hohen Wechselspannung zwischen den Elektroden, wobei kein Prozessgasstrom aufrechterhalten wird, während das Plasma brennt.

Dabei soll das zuletzt genannte Merkmal natürlich nicht implizieren, dass keinerlei Strömungsbewegung des Prozessgases im Hohlkörper auftreten könnte, sondern dass während des Brennens des Plasmas dem Hohlraum Prozessgas weder zugeführt wird noch entströmt.

## Patentansprüche

1. Verfahren zum Plasmabehandeln einer Oberfläche in einem Hohlkörper (4), umfassend folgende Verfahrensschritte:
- Füllen eines Hohlkörpers (4), der eine Wand aus dielektrischem Material aufweist, mit einem Prozessgas,
- gasdichtes Verschließen des Hohlkörpers (4),
- Einbringen des gasdicht verschlossenen Hohlkörpers (4) in einen Raum (5) zwischen mindestens zwei Elektroden (1, 2), wobei in diesem Raum (5) ein Außendruck von mindestens 0,5 bar herrscht, während in einem Innenraum des Holkörpers (4) ein Innendruck von ebenfalls mindestens 0,5 bar herrscht, und wobei der Raum (5) zwischen den Elektroden (1, 2) mit einem Gas gefüllt ist, das bei dem Außendruck eine höhere Zündfeldstärke aufweist als das Prozessgas bei dem Innendruck,
- Zünden eines Plasmas im Innenraum des Hohlkörpers (4) durch Anlegen einer hinreichend hohen Wechselspannung zwischen den Elektroden (1, 2),
wobei dadurch eine Außenfläche eines vor dem Verschließen des Hohlkörpers (4) in den Hohlkörper (4) eingebrachten Gegenstands behandelt wird.

2. Verfahren nach Anspruch 1, **dadurch gekennzeichnet, dass** der Außendruck höchstens so groß ist wie der Innendruck.

3. Verfahren nach einem der Ansprüche 1 oder 2, **dadurch gekennzeichnet, dass** ausschließlich im Innenraum des Hohlkörpers (4) ein Plasma erzeugt wird.

4. Verfahren nach einem der Ansprüche 1 bis 3, **dadurch gekennzeichnet, dass** für den Außendruck und/oder für den Innendruck ein Wert von höchstens 10 bar, vorzugsweise ein Wert von zwischen 0,8 bar und 2 bar, gewählt wird.

5. Verfahren nach einem der Ansprüche 1 bis 4, **dadurch gekennzeichnet, dass** das Plasma als Volumenplasma (6) erzeugt wird, welches sich von einer Wand des Hohlkörpers (4) bis zu einer gegenüberliegenden Wand des Hohlkörpers (4) erstreckt.

6. Verfahren nach einem der Ansprüche 1 bis 5, **dadurch gekennzeichnet, dass** zu behandelnde Teile der Oberfläche für eine Dauer von zwischen 5 s und 300 s mit dem Plasma in Kontakt gebracht werden.

7. Verfahren nach einem der Ansprüche 1 bis 6, **dadurch gekennzeichnet, dass** mindestens eine der Elektroden (1, 2) direkt an den Hohlkörper (4) angelegt wird.

8. Verfahren nach einem der Ansprüche 1 bis 7, **dadurch gekennzeichnet, dass** mindestens eine der Elektroden (1, 2) bewegt wird, während das Plasma brennt.

9. Verfahren nach einem der Ansprüche 1 bis 8, **dadurch gekennzeichnet, dass** das Prozessgas Helium und/oder Argon und/oder ein anderes Edelgas enthält.

10. Verfahren nach einem der Ansprüche 1 bis 9, **dadurch gekennzeichnet, dass** dem Prozessgas mindestens ein Prekursor beigemischt wird.

11. Verfahren nach Anspruch 10, **dadurch gekennzeichnet, dass** der mindestens eine Prekursor dem Prozessgas beigefügt wird, indem das Prozessgas vor dem Füllen des Hohlkörpers (4) durch den Prekursor geleitet wird.

12. Verfahren nach einem der Ansprüche 1 bis 11, **dadurch gekennzeichnet, dass** dadurch auch eine innere Wandoberfläche des Hohlkörpers (4) beschichtet und/oder funktionalisiert wird.

13. Verfahren nach einem der Ansprüche 1 bis 12, **dadurch gekennzeichnet, dass** es sich bei dem Gegenstand um einen Stopfen (8) oder eine Mikrotiterplatte handelt.

14. Verfahren nach einem der Ansprüche 1 bis 13, **dadurch gekennzeichnet, dass** der Gegenstand durch Rütteln des Hohlkörpers (8) bewegt wird, während seine Außenfläche mit dem Plasma behandelt wird.

## Claims

1. Method for the plasma treatment of a surface in a hollow body (4) comprising the following method steps:
- filling of a hollow body (4) which has a wall made of dielectric material with a process gas,
- gas-tight sealing of the hollow body (4),
- introduction of the hollow body (4) which is sealed in a gas-tight manner into a space (5) between at least two electrodes (1, 2), an external pressure of at least 0.5 bar prevailing in this space (5), whilst an internal pressure of likewise at least 0.5 bar prevails in an internal chamber of the hollow body, and the space (5) between the electrodes (1, 2) being filled with a gas which has a higher ignition field strength at the external pressure than the process gas at the internal pressure
- ignition of a plasma in the interior of the hollow body (4) by applying a sufficiently high alternating voltage between the electrodes (1, 2),
wherein thereby, that an external surface of an object introduced into the hollow body (4) before sealing the hollow body (4) is treated.

2. Method according to claim 1, **characterised in that** the external pressure is at most as high as the internal pressure.

3. Method according to one of the claims 1 or 2, **characterised in that** a plasma is produced exclusively in the interior of the hollow body (4).

4. Method according to one of the claims 1 to 3, **characterised in that** a value of at most 10 bar, preferably a value of between 0.8 bar and 2 bar, is chosen for the external pressure and/or for the internal pressure.

5. Method according to one of the claims 1 to 4, **characterised in that** the plasma is produced as volume plasma (6) which extends from one wall of the hollow body (4) up to an oppositely-situated wall of the hollow body (4).

6. Method according to one of the claims 1 to 5, **characterised in that** parts of the surface to be treated are brought in contact with the plasma for a duration of between 5 s and 300 s.

7. Method according to one of the claims 1 to 6, **characterised in that** at least one of the electrodes (1, 2) is applied directly to the hollow body (4).

8. Method according to one of the claims 1 to 7, **characterised in that** at least one of the electrodes (1, 2) is moved while the plasma is burning.

9. Method according to one of the claims 1 to 8, **characterised in that** the process gas contains helium and/or argon and/or a different noble gas.

10. Method according to one of the claims 1 to 9, **characterised in that** at least one precursor is mixed into the process gas.

11. Method according to claim 10, **characterised in that** the at least one precursor is added to the process gas **in that** the process gas is conducted through the precursor before filling the hollow body (4).

12. Method according to one of the claims 1 to 11, **characterised in that** also an internal wall surface of the hollow body (4) is, thereby, coated and/or functionalised.

13. Method according to one of the claims 1 to 12, **characterised in that** the object is a stopper (8) or a microtitre plate.

14. Method according to one of the claims 1 or 13, **characterised in that** the object is moved by shaking the hollow body (8) while the external surface thereof is treated with the plasma.

## Revendications

1. Procédé de traitement plasma d'une surface dans un corps creux (4), comprenant les étapes de procédé suivantes :
- remplissage d'un corps creux (4), qui présente une paroi en matériau diélectrique, avec un gaz de procédé,
- fermeture du corps creux (4) de manière étanche au gaz,
- introduction du corps creux (4), fermé de manière étanche au gaz, dans un espace (5) entre au moins deux électrodes (1, 2), sachant que règne dans cet espace (5) une pression extérieure d'au moins 0,5 bar, tandis qu'une pression intérieure également d'au moins 0,5 bar règne dans l'espace intérieur du corps creux (4), et sachant que l'espace (5) entre les électrodes (1, 2) est rempli d'un gaz qui à la pression extérieure présente une intensité de champ d'allumage supérieure à celle du gaz de traitement à la pression intérieure,
- allumage d'un plasma dans l'espace intérieur du corps creux (4) par l'application d'une tension alternative suffisamment élevée entre les électrodes (1, 2),
une surface extérieure d'un objet introduit dans le corps creux (4) avant la fermeture du corps creux (4) étant ainsi traitée.

2. Procédé selon la revendication 1, **caractérisé en ce que** la pression extérieure est au plus égale à la pression intérieure.

3. Procédé selon la revendication 1 ou 2, **caractérisé en ce qu'**un plasma est produit exclusivement dans l'espace intérieur du corps creux (4).

4. Procédé selon l'une des revendications 1 à 3, **caractérisé en ce qu'**on choisit pour la pression extérieure et/ou pour la pression intérieure une valeur d'au plus 10 bars, de préférence une valeur comprise entre 0,8 bar et 2 bars.

5. Procédé selon l'une des revendications 1 à 4, **caractérisé en ce que** le plasma est produit sous forme de plasma volumique (6), qui s'étend depuis une paroi du corps creux (4) jusqu'à une paroi opposée du corps creux (4).

6. Procédé selon l'une des revendications 1 à 5, **caractérisé en ce que** des parties à traiter de la surface sont mises en contact avec le plasma pendant une durée comprise entre 5 s et 300 s.

7. Procédé selon l'une des revendications 1 à 6, **caractérisé en ce qu'**au moins une des électrodes (1, 2) est directement appliquée contre le corps creux (4).

8. Procédé selon l'une des revendications 1 à 7, **caractérisé en ce qu'**au moins une des électrodes (1, 2) est déplacée pendant que le plasma brûle.

9. Procédé selon l'une des revendications 1 à 8, **caractérisé en ce que** le gaz de procédé contient de l'hélium et/ou de l'argon et/ou un autre gaz rare.

10. Procédé selon l'une des revendications 1 à 9, **caractérisé en ce qu'**au moins un précurseur est mélangé au gaz de procédé.

11. Procédé selon la revendication 10, **caractérisé en ce que** le au moins un précurseur est ajouté au gaz de procédé par le fait que le gaz de procédé est dirigé à travers le précurseur avant le remplissage du corps creux (4).

12. Procédé selon l'une des revendications 1 à 11, **caractérisé en ce qu'**également à travers lui une surface de paroi intérieure du corps creux (4) est revêtue et/ou fonctionnalisée.

13. Procédé selon l'une des revendications 1 à 12, **caractérisé en ce que** l'objet est un bouchon (8) ou une plaque microtitre.

14. Procédé selon l'une des revendications 1 à 13, **caractérisé en ce que** l'objet est déplacé en secouant le corps creux (4) pendant que sa surface extérieure est traitée avec le plasma.
